# EUROPEAN PATENT APPLICATION

(11) **EP 3 062 404 A1**
(43) Date of publication of application: **31.08.2016**
(21) Application number: 16156816.7
(22) Date of filing: 23.02.2016
(51) Int. Cl.: H02B 13/025, H02B 1/28

(54) **PRESSURE RELIEF MECHANISM FOR AN ELECTRICAL HOUSING AND METHOD**

(30) Priority: 24.02.2015 US 201514630145
(71) Applicant: General Electric Company, Schenectady, NY 12345 (US)
(72) Inventor: RAJAURIA, Samir, 500003 Secunderabad (IN); JAKKIREDDY, Ayyappa Reddy, 500003 Secunderabad (IN); KURRA, Guru Moorthy, 500003 Secunderabad (IN); POKKULA, Lenin, 500003 Secunderabad (IN)
(74) Representative: Fischer, Jens Peter

(57) **Abstract**

A pressure relief system (40) for an electrical housing (2) includes at least one wall (8, 10, 12, 14) having a first surface (26) defining, at least in part, a compartment (4), and a second surface (28) defining, at least in part, a ventilation passage (20). The at least one wall (8, 10, 12, 14) includes an opening (30) fluidically connecting the compartment (4) and the ventilation passage (20). The pressure relief system (40) includes a closure (44) mounted to the at least one wall (8, 10, 12, 14) at the opening (30). The closure (44) is selectively moveable between a closed position and an open position. A biasing member (94) is coupled to the closure (44). The biasing member (94) is operative to bias the closure (44) to the closed position and, in response to a pressure wave (120) within the compartment (4), allow the closure (44) to move to the open position. The biasing member (94) is further operative to bias the closure (44) to the closed position after at least a portion of the pressure wave (120) has passed from the compartment (4).

## Description

### BACKGROUND OF THE INVENTION

The subject matter disclosed herein relates to the art of electrical housings and, more particularly, to a pressure relief mechanism for an electrical housing and method.

Electrical switching and protection components are typically mounted in a housing. For example, an electrical housing may include circuit breaker compartments that support, and protect one or more circuit breakers. Conventional circuit breakers, in addition to providing over current protection, also provide protection during arc fault events. During an arc fault event, gases often develop and expand outwardly from the circuit breaker. The gases are passed into a vent which provides ventilation of the electrical housing.

### BRIEF DESCRIPTION OF THE INVENTION

According to one aspect of an exemplary embodiment, a pressure relief system for an electrical housing includes at least one wall having a first surface defining, at least in part, a compartment, and a second surface defining, at least in part, a ventilation passage. The at least one wall includes an opening fluidically connecting the compartment and the ventilation passage. The pressure relief system includes a closure mounted to the at least one wall at the opening. The closure is selectively moveable between a closed position covering the opening and an open position uncovering the opening and fluidically connecting the compartment and the ventilation passage. A biasing member is coupled to the closure. The biasing member is operative to bias the closure to the closed position and, in response to a pressure wave within the compartment, allow the closure to move to the open position fluidically connecting the compartment and the ventilation passage. The biasing member is further operative to bias the closure to the closed position after at least a portion of the pressure wave has passed from the compartment into the ventilation passage.

According to another aspect of an exemplary embodiment, a method of ventilating a circuit breaker compartment in an electrical housing includes opening a pressure relief system in response to a selected peak value of a pressure wave in a compartment of the electrical housing, and closing the pressure relief system after at least a portion of the pressure wave has exhausted from the compartment.

These and other advantages and features will become more apparent from the following description taken in conjunction with the drawings.

### BRIEF DESCRIPTION OF DRAWINGS

The subject matter, which is regarded as the invention, is particularly pointed out and distinctly claimed in the claims at the conclusion of the specification. The foregoing and other features, and advantages of the invention are apparent from the following detailed description taken in conjunction with the accompanying drawings in which:
FIG. 1 depicts an electrical housing including a pressure relief system, in accordance with an exemplary embodiment, shown in a closed configuration;
FIG. 2 depicts an electrical housing of FIG. 1 illustrating the pressure relief system in an open configuration;
FIG. 3 is an end view of the pressure relief system of FIG. 1;
FIG. 4 is an end view of the pressure relief system of FIG. 2;
FIG. 5 is a plan view of the pressure relief system, in accordance with an exemplary embodiment;
FIG. 6 is an exploded view of the pressure relief system of FIG. 5; and
FIG. 7 is a graph depicting an initial opening of the pressure relief system relative to a peak of a pressure wave, in accordance with an exemplary embodiment.

The detailed description explains embodiments of the invention, together with advantages and features, by way of example with reference to the drawings.

### DETAILED DESCRIPTION OF THE INVENTION

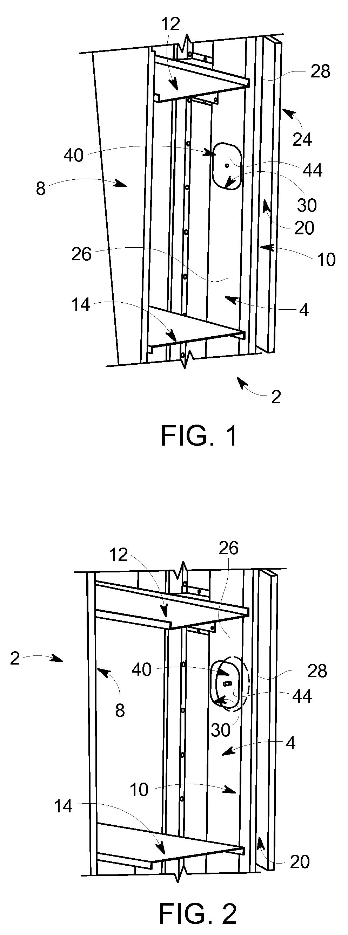

An electrical housing, in accordance with an exemplary embodiment, is illustrated generally at 2, in FIG. 1. Electrical housing 2 includes a compartment 4 which, in accordance with an aspect of an exemplary embodiment, may be a circuit breaker compartment. Of course, it should be understood that compartment 4 may house other electrical components. Compartment 4 is defined by a first side wall 8, a second side wall 10, a third side wall 12, and a fourth side wall 14. A ventilation passage 20 may be arranged outwardly of compartment 4. In the exemplary embodiment shown, ventilation passage 20 is defined between second side wall 10 and another wall 24. In further accordance with the exemplary embodiment shown, second side wall 10 includes a first surface 26 and an opposing, second surface 28. An opening 30 extends through the first and second surfaces 26 and 28 fluidically connecting compartment 4 and ventilation passage 20.

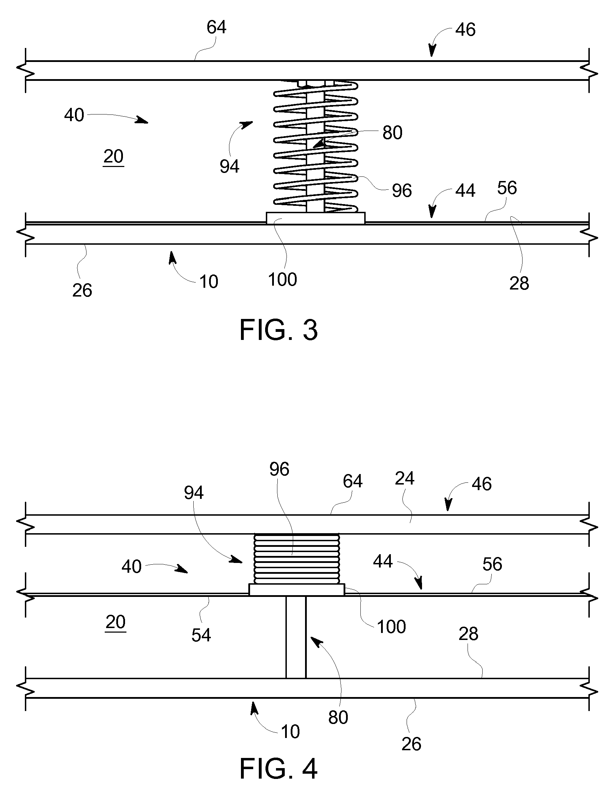

In accordance with an exemplary embodiment, electrical housing 2 includes a pressure relief system 40 arranged at opening 30. Pressure relief system 40 shifts between a normally closed position, such as shown in FIGs. 1 and 3, and an open position, such as shown in FIGs. 2 and 4, in response to a pressure wave in compartment 4. More specifically, in the event of a build-up of gases, such as may occur during an arc fault event, pressure relief system 40 opens. Upon opening, the pressure wave carries the gases from compartment 4 to ventilation passage 20.

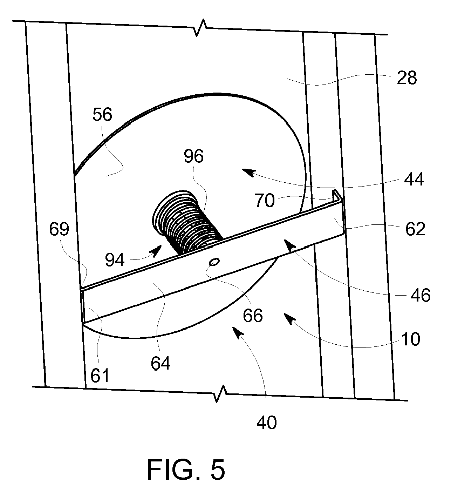

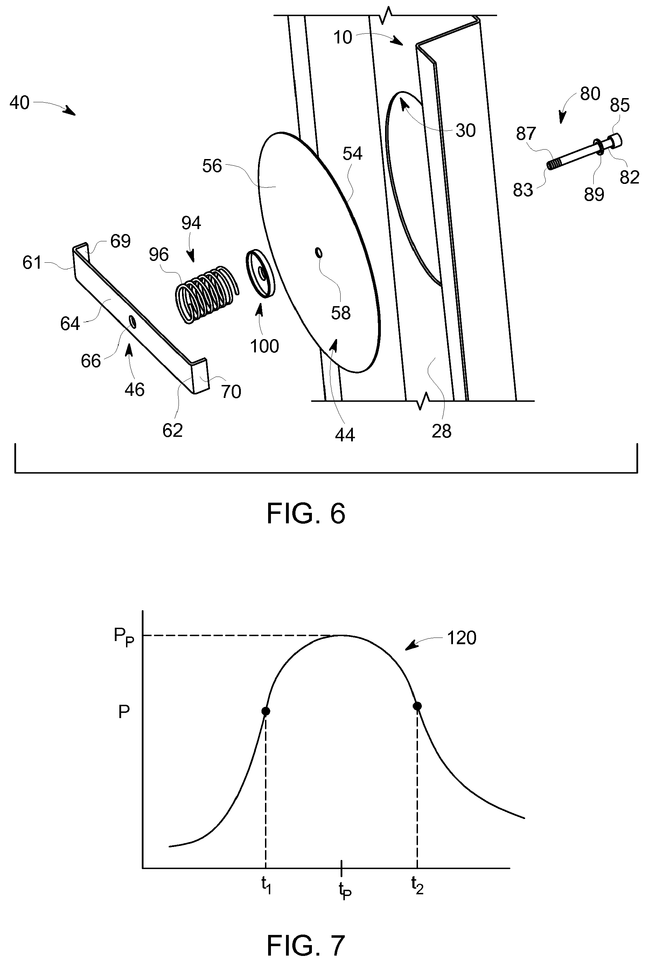

As shown in FIGs. 5 and 6, pressure relief system 40 includes a closure or plate member 44 and a support bracket 46. Plate member 44 includes a first surface 54 and an opposing, second surface 56. An opening 58 extends through first and second surfaces 54 and 56. Support bracket 46 extends from a first end 61 to a second end 62. An intermediate portion 64 extends between first and second ends 61 and 62. An opening 66 extends through intermediate portion 64 of support bracket 46. Opening 66 may take the form of a threaded opening. A first flange 69 is arranged at first end 61 and a second flange 70 is arranged at second end 62. First and second flanges 69 and 70 provide an attachment interface with second side wall 10 as well as a desired spacing from second surface 28.

Pressure relief system 40 also includes a rod 80 that operatively connects plate member 44 to support bracket 46. Rod 80 includes a first end portion 82 and a second end portion 83. In the exemplary embodiment shown, rod 80 may take the form of a mechanical fastener or bolt (not separately labeled) having a head 85 at first end portion 82 and threads 87 at second end portion 83. A washer 89 may be provided on rod 80 adjacent to head 85. Rod 80 extends through opening 58 in plate member 44 and operatively connects with support bracket 46 at opening 66. In this manner, first end portion 82 is cantilevered from support bracket 46. Plate member 44 may transition from head 85 toward second end portion 83 between an open configuration (FIG. 3) and a closed configuration (FIG. 4).

A biasing member 94 provides a biasing force that urges plate member 44 toward head 85. Thus, biasing member 94 urges plate member 44 into a normally closed configuration. In the exemplary embodiment shown, biasing member 94 takes the form of a coil spring 96 that extends about rod 80 between intermediate portion 64 of support bracket 46 and second surface 56 of plate member 44. A spring seat 100 may be provided at second surface 56 to enhance alignment of coil spring 96 and rod 80. Another spring seat (not shown) may be provided at intermediate portion 64 of support bracket 46.

In accordance with an aspect of an exemplary embodiment, biasing member 94 includes a spring constant designed to allow plate member 44 to shift along rod 80 at a predetermined pressure. More specifically, a pressure wave 120, such as shown in FIG. 7, may be generated in compartment 4. Pressure wave 120 may result from gases generated during an arcing event. Pressure wave 120 includes an expected peak value of Pₚ at a time tₚ. Biasing member 94 includes a spring constant that is selected to allow plate member 44 to begin exposing opening 30 at a time t₁ before pressure wave 120 reaches a selected peak value Pₚ. That is, biasing member 94 begins to deform or compress before pressure wave 120 reaches the expected peak value Pₚ. The spring constant of biasing member 94 is also selected to allow plate member 44 to begin to return to the closed configuration at time t₂ that occurs after the selected peak value Pₚ. In this manner, compartment 4 is never exposed to peak pressure during an arc fault event. Pressure relief system 40 begins to open before peak pressure is reached allowing pressure wave 120 to carry gases from compartment 4 before the peak is ever achieved thereby reducing the degree of pressure exposure to, for example, compartment 4. Thus, pressure relief system 40 responds to pressure wave 120 before damage occurs in circuit breaker compartment 4.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

Various aspects and embodiments of the present invention are defined by the following numbered clauses:
1. A pressure relief system for an electrical housing, the electrical housing including at least one wall having a first surface defining, at least in part, a compartment, and a second surface defining, at least in part, a ventilation passage, the at least one wall including an opening fluidically connecting the compartment and the ventilation passage, the pressure relief system comprising:
   a closure mounted to the at least one wall at the opening, the closure being selectively moveable between a closed position covering the opening and an open position uncovering the opening and fluidically connecting the compartment and the ventilation passage; and
   a biasing member coupled to the closure, the biasing member operative to bias the closure to the closed position and, in response to a pressure wave within the compartment, allow the closure to move to the open position fluidically connecting the compartment and the ventilation passage, the biasing member being further operative to bias the closure to the closed position after at least a portion of the pressure wave has passed from the compartment into the ventilation passage.
2. The electrical housing according to clause 1, wherein the pressure relief system is mounted to the second surface.
3. The electrical housing according to any preceding clause, wherein the pressure relief system includes a support bracket mounted to the second surface and at least one plate member shiftably mounted relative to the support bracket.
4. The electrical housing according to any preceding clause, wherein the biasing member is configured and disposed to deform allowing the at least one plate member to shift away from the opening at a pressure value that is less than a selected peak value of a pressure wave in the compartment.
5. The electrical housing according to any preceding clause, further comprising:
   a rod fixedly mounted to the at least one plate member, the rod extending through and being shiftable relative to the support bracket.
6. The electrical housing according to any preceding clause, wherein the biasing member comprises a coil spring extending about the rod.
7. The electrical housing according to any preceding clause, wherein the coil spring is arranged between the support bracket and the at least one plate member.
8. The electrical housing according to any preceding clause, further comprising:
   a spring seat provided at one of the support bracket and the at least one plate member, the spring seat receiving an end portion of the coil spring.
9. The electrical housing according to any preceding clause, wherein in the support bracket includes a first end, a second end and an intermediate portion extending therebetween, the first end including a first flange mounted to the second surface outwardly of the opening, the second end including a second flange mounted to the second surface outwardly of the opening, and the intermediate portion including a threaded opening.
10. The electrical housing according to any preceding clause, further comprising:
   a rod threadably engaged with the threaded opening, the at least one plate member being selectively shiftable along the rod.
11. The electrical housing according to any preceding clause, wherein the compartment comprises a circuit breaker compartment.
12. A method of ventilating a circuit breaker compartment in an electrical housing, the method comprising:
   opening a pressure relief system in response to a selected peak value of a pressure wave in a compartment of the electrical housing; and
   closing the pressure relief system after at least a portion of the pressure wave has exhausted from the compartment.
13. The method of any preceding clause, further comprising: initiating opening of the pressure relief system prior to the pressure wave reaching the selected peak value.
14. The method of any preceding clause, wherein closing the pressure relief system includes biasing a plate member to a wall of the electrical housing after the pressure wave reaches the selected peak value.
15. The method of any preceding clause, wherein opening the pressure relief system includes urging a plate member against a biasing force.
16. The method of any preceding clause, wherein urging the plate member against the biasing force includes compressing a coil spring.
17. The method of any preceding clause, wherein opening the pressure relief system includes unseating a plate member to expose an opening formed in a wall of the electrical housing.
18. The method of any preceding clause, wherein opening the pressure relief system includes exposing an opening formed in a circuit breaker compartment of the electrical housing.
19. The method of any preceding clause, wherein opening the pressure relief system includes shifting a plate member along a rod supported at the wall of the electrical housing.
20. The method of any preceding clause, wherein opening the pressure relief system includes exposing the compartment to a ventilation passage formed in the electrical housing.

## Claims

1. A pressure relief system (40) for an electrical housing (2), the electrical housing (2) including at least one wall (8, 10, 12, 14) having a first surface (26) defining, at least in part, a compartment (4), and a second surface (28) defining, at least in part, a ventilation passage (20), the at least one wall (8, 10, 12, 14) including an opening (30) fluidically connecting the compartment (4) and the ventilation passage (20), the pressure relief system (40) comprising:
a closure (44) mounted to the at least one wall (8, 10, 12, 14) at the opening (30), the closure (44) being selectively moveable between a closed position covering the opening (30) and an open position uncovering the opening (30) and fluidically connecting the compartment (4) and the ventilation passage (20); and
a biasing member (94) coupled to the closure (44), the biasing member (94) operative to bias the closure (44) to the closed position and, in response to a pressure wave (120) within the compartment (4), allow the closure (44) to move to the open position fluidically connecting the compartment (4) and the ventilation passage (20), the biasing member (94) being further operative to bias the closure (44) to the closed position after at least a portion of the pressure wave (120) has passed from the compartment (4) into the ventilation passage (20).

2. The electrical housing (2) according to claim 1, wherein the pressure relief system (40) is mounted to the second surface (28).

3. The electrical housing (2) according to claim 2, wherein the pressure relief system (40) includes a support bracket (46) mounted to the second surface (28) and at least one plate member (44) shiftably mounted relative to the support bracket (46).

4. The electrical housing (2) according to claim 3, wherein the biasing member (94) is configured and disposed to deform allowing the at least one plate member (44) to shift away from the opening (30) at a pressure value that is less than a selected peak value of a pressure wave (120) in the compartment (4).

5. The electrical housing (2) according to claim 3 or 4, further comprising: a rod (80) fixedly mounted to the at least one plate member (44), the rod (80) extending through and being shiftable relative to the support bracket (46).

6. The electrical housing (2) according to claim 5, wherein the biasing member (94) comprises a coil spring (96) extending about the rod (80).

7. The electrical housing (2) according to claim 6, wherein the coil spring (96) is arranged between the support bracket (46) and the at least one plate member (44).

8. The electrical housing (2) according to claim 7, further comprising: a spring seat (100) provided at one of the support bracket (46) and the at least one plate member (44), the spring seat (100) receiving an end portion (82,83) of the coil spring (96).

9. The electrical housing (2) according to claim 3 or any of claims 4 to 8 when dependent upon claim 3, wherein in the support bracket (46) includes a first end (61), a second end (62) and an intermediate portion (64) extending therebetween, the first end (61) including a first flange (69) mounted to the second surface (28) outwardly of the opening (30), the second end (70) including a second flange (70) mounted to the second surface (28) outwardly of the opening (30), and the intermediate portion (64) including a threaded opening (66).

10. The electrical housing (2) according to claim 9, further comprising: a rod (80) threadably engaged with the threaded opening (66), the at least one plate member (44) being selectively shiftable along the rod (80).

11. A method of ventilating a circuit breaker compartment in an electrical housing, the method comprising:
opening a pressure relief system in response to a selected peak value of a pressure wave in a compartment of the electrical housing; and
closing the pressure relief system after at least a portion of the pressure wave has exhausted from the compartment.
